# EUROPEAN PATENT APPLICATION

(11) **EP 3 832 333 A1**
(43) Date of publication of application: **09.06.2021**
(21) Application number: 19212824.7
(22) Date of filing: 02.12.2019
(51) Int. Cl.: G01R 33/30

(54) **METHOD AND DEVICE FOR DELIVERING A LIQUID SAMPLE MATERIAL TO A SPECTROMETER SETUP**

(71) Applicant: Universität Wien, 1010 Vienna (AT)
(72) Inventor: Kress, Thomas, 1090 Vienna (AT); Kurzbach, Dennis, 1090 Vienna (AT)
(74) Representative: Patentanwaltskanzlei Matschnig & Forsthuber OG

(57) **Abstract**

In order to deliver a liquid sample material to a sample holder arrangement of an NMR spectrometer setup and into an NMR sample tube (25), a first volume (Vi) of the liquid sample material is transferred from a sample reservoir (12) into a receiving section (21) of a delivery line (20). The delivery line (20), downstream of the receiving section (21), ends in an outlet end (24) where it is connected to the sample holder arrangement. Displacing liquid is provided in a displacement reservoir (22), which is connected to the receiving section (21) of the delivery line upstream thereof. A second volume (V₂) of the displacing liquid is delivered from the displacement reservoir (22) into the delivery line (20), whose volume is smaller than the sum of the first and the second volumes, thus forcing a portion (V_{D}) of the liquid sample material in the receiving section through the delivery line toward and into the sample tube (25).

## Description

### Field of the invention

The invention relates to a sample delivery device and a method for delivering a liquid sample material to a spectrometer setup, such as NMR (nuclear magnetic resonance) spectrometer setup. More specifically, the invention relates to a method for rapidly injecting a pre-defined volume of liquid into a sample tube situated within, for instance, an NMR spectrometer.

This type of sample delivery is of general use, but is of particular interest in the context of real-time NMR experiments where a liquid is injected into an NMR tube and mixed with another liquid that is already present ("waiting") in the NMR tube. Real-time NMR techniques may be applied to gather information about the temporal evolution of solutions in a non-invasive way. Processes that evolve towards equilibrium after mixing of two interaction partners can be, for instance, chemical reactions, non-covalent interactions such as crystallization events or biological interactions such as protein-ligand binding processes. Non-equilibrium systems can be generated by rapidly mixing two solutions, each containing a reaction or interaction partner.

### Description of prior art

Several devices have already been developed for the purpose of injecting liquids into NMR setups, and in particular for real-time NMR experiments. For instance, Mok et al., in "Rapid sample-mixing technique for transient NMR and photo-CIDNP spectroscopy: Applications to real-time protein folding", J. Am. Chem. Soc. 2003, 125 (41), 12484-12492, presents a system that injects a solution within tens of milliseconds into an NMR tube and mixes it within the tube with a waiting solution. Furthermore, continuous flow devices for reaction monitoring of slow reactions are available (see, e.g., US 2012/0092013 A1). These devices are adapted for experiments with high signal intensities, or slow reaction rates.

Real-time NMR applications are often limited by the weak signal intensities. One way to enhance NMR signal intensities is to use dissolution DNP (dynamic nuclear polarization). This method enables the transfer of a hyperpolarized solution from a dedicated hyperpolarization apparatus to an NMR spectrometer for detection. A hyperpolarized nuclear spin system is one in which the nuclear magnetic moments of the sample are more strongly aligned with an external magnetic field (*B₀*) relative to the Boltzmann thermal-equilibrium state for given temperature (*T*) and *B*₀*.* Such samples can provide correspondingly large signals in NMR, magnetic resonance imaging (MRI), magnetic resonance spectroscopy (MRS), or MRS imaging (MRSI). Molecular carriers of nuclear hyperpolarization are thus highly valued as high-sensitivity probes for imaging or spectroscopy. For dissolution DNP applications, the hyperpolarization procedure is typically performed at cryogenic temperatures < 4 K in strong magnetic fields > 3 T. After completion of the hyperpolarization procedure, the hyperpolarized sample is quickly transferred to an NMR spectrometer, in order to be able to use the polarization which decays according to the characteristic decay time *T*₁, for which a typical value is in the range of about 1 to 60 s. As one example of a DNP setup, International Application WO 02/37132 A1 describes a setup in which a sample is dissolved within the polarizer with a hot solution, and then pushed towards an NMR spectrometer with high pressure compressed gas for detection. The volume injected is typically controlled through the pressure of the compressed gas, and a push time, but depends on many more parameters that are very difficult to control (such as temperature and pressure of the fluid before dissolution, temperature of the cryostat). This generally results in an inaccurate control of the volume injected in the spectrometer. In addition, the gas that is dissolved in the solution due to high pressures and temperature is released in the NMR tube upon injection which perturbs the magnetic field homogeneity of the magnet and limits the use of complex multidimensional NMR experiments.

### Summary of the invention

In view of the above, there is a need for a setup that allows to rapidly inject a liquid sample material into a sample tube of an NMR spectrometer (or other spectrometer types), where the setup is compatible with common Dissolution Dynamic Nuclear Polarization (DDNP) applications.

This aim is met by a sample delivery device for delivering ("injecting") a liquid sample material to an NMR spectrometer setup, or more generally a spectrometer for measuring a liquid-state sample, said device comprising:
a sample reservoir (also referred to as "collector") configured for containing said liquid sample material,
a delivery line which is connectable, through an outlet end thereof, to a sample holder arrangement of said spectrometer setup, and
a displacement reservoir which is configured to contain a displacing liquid and is connected to the receiving section upstream thereof.

Therein, the delivery line has a known volume, referred to as line volume; the delivery line comprises a receiving section and a delivery section ending in said outlet end, wherein the receiving section, delivery section, and the outlet end are in fluid communication; the receiving section is configured to receive, from the sample reservoir, a first volume of said liquid sample material to be delivered to said spectrometer setup; and the displacement reservoir and deliver an adjustable second volume of the displacing liquid to the delivery line. The sum of the first and the second volumes is larger than the line volume, thus displacing liquid from the receiving section towards and through the outlet end. Thus, the volume delivered to the spectrometer setup is the difference between the line volume and the sum of the first and second volumes.

This solution according to the invention ensures rapidly injecting a pre-defined volume of liquid into a sample holder arrangement (which will usually include an NMR tube/ spectrometer tube of common type) situated within an NMR spectrometer (or other liquid-state sample spectrometer). This is advantageous, in particular, for use in real-time NMR experiments where a liquid is injected into an NMR tube and mixed with another liquid that is waiting in the NMR tube ("waiting solution"). It achieves injecting a pre-defined volume of solution in an NMR spectrometer with a device that is compatible with common dissolution DNP setups and allows for mixing of an hyperpolarized solution with a waiting solution in an NMR spectrometer in less than three seconds while enabling rapid settling convection of the liquid. The setup can be implemented as a light, mobile and compact device that can be readily and rapidly attached to and detached from any NMR spectrometer, and can be operated by a single person. Furthermore, the sample delivery device according to the invention is compatible with gas pressures up to 10 bar, ensuring its compatibility with often-used types of liquid transfer systems, in particular for Dissolution Dynamic Nuclear Polarization (DDNP) applications. The system is designed for use with conventional 5 mm NMR tubes, but can easily be adapted to other tube diameters, e.g. 3, 10 or 20 mm, as well.

Thus, a method for delivering a liquid sample material to a sample holder arrangement of a spectrometer setup (for instance an NMR spectrometer setup), will comprise, according to the invention the steps of:
- providing a liquid sample material, of which at least a fraction is to be delivered to said spectrometer setup,
- transferring a first volume of said liquid sample material into a receiving section of a delivery line, wherein the delivery line comprises, downstream of the receiving section, a delivery section ending in an outlet end through which the delivery line is connected to the sample holder arrangement,
- providing an amount of a displacing liquid in a displacement reservoir, said displacement reservoir being connected to the receiving section of the delivery line upstream thereof,
- delivering a second volume of the displacing liquid from the displacement reservoir to the delivery line, thus forcing the liquid sample material in the receiving section through the delivery line toward and into said spectrometer setup.

Therein, as mentioned before, the delivery line has a known line volume, and the sum of the first and the second volumes is larger than the line volume, in order to ensure that liquid is displace from the receiving section towards and through the outlet end.

In an advantageous development of the invention, the delivery line may comprise a sensor indicating the presence of an amount of liquid in the receiving section corresponding to the first volume. This allows control of the presence of sample liquid in an efficient manner. For instance, the sensor may be an optical liquid sensor. In a suitable development of the sample delivery device according to the invention, the portion of the delivery line upstream of the sensor represents the receiving section. Furthermore, in order to allow a simple way of adjusting the first volume to a desired value, the sensor may be movable along the delivery line.

Furthermore, in many advantageous embodiments, the sample reservoir comprises a collector volume having an outlet connected to the sample delivery line, wherein within the collector volume a vortex breaker element located is located in front said outlet, which vortex breaker element is designed for reducing vortices when the liquid sample material is flowing out of the collector volume through said outlet. This helps avoiding that air or other gases are mixed into the sample material when the latter is fed into the delivery line. In order to further reduce the effect of vortices, the collector volume may have a funnel-shaped bottom surface ending into the outlet connected to the sample delivery line.

In order to avoid that displacing liquid is transferred into the spectrometer, the displacement reservoir may be configured to deliver a second volume which is not larger than the line volume.

The displacement reservoir may be realized as a cylinder with a moveable plunger or piston connected to an actuating mechanism for realizing the delivery of displacing liquid to the delivery line. Furthermore, a particularly useful implementation of the sample delivery device according to the invention represents a modular unit which comprises the sample reservoir, the displacement reservoir including an actuating mechanism thereof, and connection lines connecting the sample reservoir and displacement reservoir to the receiving section; preferably the modular unit also comprises at least the receiving section or the entire delivery line. Such a modular unit can readily be combined with different spectrometers, without having to modify the respective hardware.

In another suitable development, the sample reservoir may be connected to a vacuum line through a valve. This will allow depressurizing the sample reservoir for degassing the sample material contained in the sample reservoir, prior to transferring the first volume of said liquid sample material into the receiving section.

Another aspect of the invention relates to a sample adaptor which is suitable for use in combination with the sample delivery device. Such a sample adaptor, which is attachable to an spectrometer sample tube is preferably configured for being connected to a sample delivery device (such as the above-described sample delivery device, thus forming a sample injection system according to the invention) and includes:
an adaptor body, and
an adaptor connector mounted, preferably releasably mounted, to the adaptor body, the adaptor connector configured for pressure-tight mounting of an NMR sample tube;
therein, the adaptor body and the adaptor connector define a cavity which forms an additional headspace of the spectrometer sample tube, preferably on top of the sample tube; the adaptor body is provided with an opening for mounting a tube as an outlet end of said sample delivery device, wherein said tube extends with its tip into the spectrometer sample tube when the latter is mounted. Preferably, the adapter body has an outlet opening extending from the cavity, and this outlet opening may be connected to a pneumatic line, preferably to a vacuum line.

Furthermore, this sample adaptor may comprise a controlled valve arranged at the outlet opening, which valve is connectable to a controller of the sample delivery device for opening the outlet opening only during injection of a liquid sample through the tube forming the outlet end.

### Brief description of the drawings

In the following, in order to further demonstrate the present invention, illustrative and non-restrictive embodiments are discussed, as shown in the drawings. The drawings show:
- Fig. 1: a schematic overview of the sample delivery device according to a first embodiment of the invention;
- Fig. 2: a simplified schematic of a second embodiment illustrating the operating principle of the sample delivery device of the invention;
- Fig. 3: a cross sectional view of a sample injector arrangement including a sample adaptor according to the invention;
- Fig. 4: a perspective side view of the sample holder of Fig. 3;
- Fig. 5: a perspective side view of the collector used in the sample delivery device of Fig. 1;
- Fig. 6: a longitudinal sectional view of the collector of Fig. 5; and
- Fig. 7: a top view of the collector of Fig. 5; the line denoted A-A indicates the plane of the longitudinal section corresponding to Fig. 6.

### Detailed description of embodiments of the invention

The detailed discussion given below is intended to illustrate the invention and exemplary embodiments thereof, as well as further advantageous developments. It will be evident to the skilled person to freely combine several or all of the embodiments and aspects discussed here as deemed suitable for a specific application of the invention. Throughout this disclosure, terms like "advantageous", "exemplary" or "preferred" indicate elements or dimensions which are particularly suitable (but not essential) to the invention or an embodiment thereof, and may be modified wherever deemed suitable by the skilled person, except where expressly stated otherwise. It will be appreciated that the invention is not restricted to the exemplary embodiments discussed in the following, which are given for illustrative purpose and merely present suitable implementations of the invention.

Within the framework of the present invention, the terms "injecting" and "injection" denote rapid delivery of a volume of a sample liquid into a target receptacle, usually the sample space of a spectrometer setup. Therein, the word "rapid" denotes that the delivery of the volume is performed within a limited time interval, the injection duration, which is smaller than a typical duration of measurement. In the context of DNP, the length of the injection duration should be sufficiently smaller than the typical decay times of the enhanced signal amplitudes obtained by dissolution-DNP process. In practice, an injection duration of not greater than a few seconds (e.g. 3 s, more generally a range of 2-5s) was found suitable.

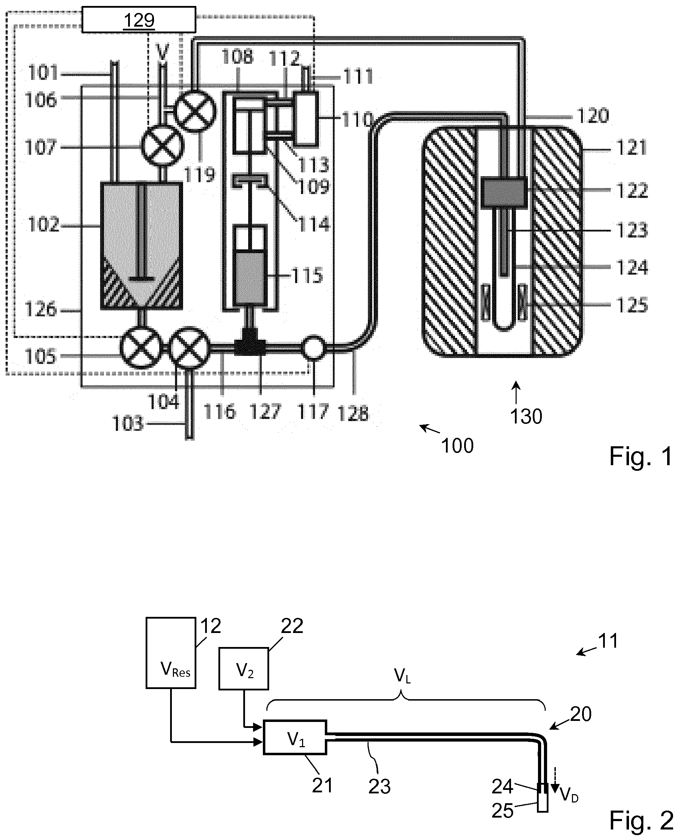

Fig. 1 shows a schematic of an injection system 100 which is a first embodiment of a sample delivery device of the invention. The components of Fig. 1 are symbolically represented, and are not to size. The system 100 (located in Fig. 1 to the left) includes the following main parts: a sample reservoir or collector 102, a displacement reservoir realized by means of a piston pump 108, and a delivery line 128; as well as valves, actuating components and various supply lines. These parts are enclosed in a casing 126, which may be realized as, e.g., plastic box that fits on top of any conventional NMR spectrometer. The system 100 is connectable to a sample injector arrangement 130 that fits inside the bore of the NMR magnet 121 of an NMR setup. The system 100 may be controlled by a controller unit such as a computer 129, for instance a PC provided with suitable drivers; the computer 129, based on user instructions input to the computer, controls the various valves and actuating components, in agreement with the user instructions and signals received from sensors such as the sensor 117 as discussed below.

The collector 102 is provided with an inlet 101, which may be realized as, e.g., a capillary through which the sample liquid is introduced into the system, for storing in the collector 102 from which it is further distributed as described below. Inlet 101 guides the liquid, but can also be used for introducing a continuous flow of gas to the system; for instance with a gas pressure of several bar, e.g. 5 bar. (All pressure values stated herein are gauge pressures, i.e. pressures relative to ambient pressure.) A vacuum line 106 is connectable to an external pump (not shown), and to vacuum line 106 the collector 102 is connected through a computer-operated valve 107 controlled by computer 129. The valve 107 is opened during the collection of the sample liquid into the collector 102; it also enables the depressurization of the collector 102 and the degassing of the liquid. After degassing of the sample liquid in the collector 102 for a suitable time interval, the valve 107 is closed. A computer-operated valve 105 is located at the outlet of the collector 102, for controlling delivery of a suitable amount of sample liquid from the collector 102. The outlet is connected to a three-way valve 104 with a first portion 116 (referred to as receiving section) of the delivery line 128. A T-fitting 127 is provided close to the three-way valve 103 and serves to connect the receiving section 116 with the displacement reservoir 115 and the main portion of the delivery line 128.

In the embodiment of Fig. 1, the displacement reservoir of the invention is realized by means of piston pump 108 including a volume-variable reservoir 115, which realizes the displacement reservoir proper of the invention, and a pneumatic cylinder 109 serving as actuator of the reservoir 115. The reservoir 115 is, for instance, a syringe which receives a defined volume of a pneumatic liquid. The syringe, more precisely its plunger (piston), is detachably connected to the pneumatic cylinder 109 through a connecting fitting 114. This allows motions of the syringe piston in both directions, in order to increase and decrease the volume of liquid held in the syringe. The piston pump 108 may advantageously be enclosed in a stainless-steel scaffolding of variable length that ensures the stability of the system and allows the tuning of the pneumatic volume of the reservoir 115. The pneumatic cylinder 109 is connected via pneumatic tubes 112 and 113 to an actuator 110, which is controlled by computer 129 and receives pressured air from a high-pressure line 111, in order to implement pushing and pulling of the pneumatic cylinder 109. The reservoir 115 is loaded with the defined volume by disconnecting its outlet temporarily for attaching a supply line of the pneumatic liquid (not shown), and filling an amount of pneumatic liquid corresponding to the defined volume into the reservoir 115, which thereafter is reconnected to its outlet. In a variant, the displacement liquid may also be provided through a permanent supply line of the pneumatic liquid, controlled e.g. by means of a computer-controlled valve. In other embodiments the displacement reservoir may be any other suitable device providing a volume-controlled reservoir, including a reciprocating pump.

Suitable choices of the displacement liquid are, for instance, water, a pneumatic oil, or a liquid organic solvent. In some cases it may be advantageous to employ, as displacement liquid, a liquid which does not mix or exchange components with the sample liquid.

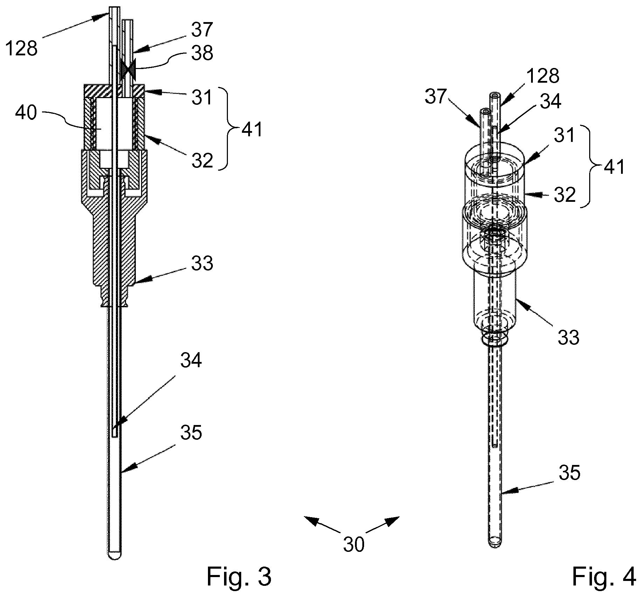

In the embodiment of Fig. 1, the delivery line 128 is realized as a capillary leading into the sample injector arrangement 130 located in the NMR spectrometer setup (in the right-hand part of Fig. 1) inside the NMR magnet 121. Advantageously the capillary is formed from a material such as PTFE, which ensures stability while having no or little dilatability with respect to the volume contained. The end of delivery line 128 is connected to a rigid tube 123 coaxial to the NMR tube 124. The bottom of tube 123 is located immediately above the NMR detection coils 125, which enables achieving a suitable compromise between a good efficiency of mixing with a liquid waiting in the tube, and the volume of solution in the detection coils. The sample holder 122, which may preferably be realized as a sample adaptor 41 described further in relation to Figs. 3 and 4 below, supports and secures tube 124 in its position; furthermore it shuts off the tube 124 in order to prevent potential leakage of liquid in the NMR system. In case of a DDNP measurement or other types of measurement using a waiting solution (or any other component which is present in the sample tube before the injection process and to which the sample fluid is injected just before a spectrometer measurement is made), the waiting solution is filled into the tube 124 before it is mounted to the sample holder 122 and inserted into the spectrometer setup. During the injection, the spaces within the sample holder 122 are maintained below atmospheric pressure, by means of a vacuum line 120. For instance the vacuum line 120 branches off from vacuum line 106 through a computer-operated valve 119, located outside the magnet.

The delivery line 128 is provided with a sensor 117, which detects the presence of a liquid at the position of the sensor at the delivery line. For instance, the sensor may be an optical liquid sensor such as the transmissive optical switch OPB82 DZ from TT Electronics (UK). The portion of delivery line 128 upstream of the sensor 117 corresponds to the receiving section of the invention (more precisely, the portion between the location of sensor 117 and the position where the displacement reservoir 115 is connected to the line 128, which in the embodiment of Fig. 1 is at T-piece 127); whereas the portion downstream corresponds to the delivery section of the invention. Advantageously the position of the sensor 117 may be changed manually along the delivery line 128, so as to calibrate the volume of compound of interest injected in the NMR tube.

The device enclosed in the casing 126 forms a modular unit which can easily be mounted or replaced as needed. It also allows, advantageously, that the device is placed within the stray magnetic field of the NMR spectrometer, for instance on top of the magnet 121.

The injection process is prepared by opening the computer-operated valve 105. A continuous flow of gas from inlet 101 of the collector 102 allows sample fluid to enter into the receiving section of the delivery line, up to the position of optical sensor 117. Once the liquid sensor 117 detects the sample liquid, the valve 105 is closed, and the computer clears the system for injection. At a specific command from the operator, or automatically after a suitable delay time upon closure of valve 105, the computer triggers the reservoir 115 to push the liquid contained in the reservoir into the receiving section; this will propel the sample liquid already present in the reserving section past the sensor 117 and through the delivery section toward and into the spectrometer setup. A typical value of the final amount of liquid (mixed liquid) in the NMR tube is 0.4 cm³. During this injection process, preferably, the valve 19 is opened in order to depressurize the NMR tube 124 so as to aid the injection of the liquid. After the injection process, all valves are closed, and the computer 129 can give a remote start signal to the spectrometer setup for starting an NMR measurement.

Preferably, the valve 105 and/or the valve 104 may also include a connection to a waste line 103, which enables cleaning the collector and the delivery line in a simple and fast way, for instance by flushing to a vacuum line.

Fig. 2 is a simplified schematic of a second embodiment which also illustrates the operating principle of the sample delivery device of the invention. Only the most important components are shown in Fig. 2, whereas the further components such as control valves, pneumatic tubing, and the computer controller have been omitted for clarity. In the sample delivery device 11 of the second embodiment, the delivery line 23 comprises (by order corresponding to the direction of flow of the sample liquid) the receiving section 21 and the delivery section 23 ending in an outlet end 24 connected to a target receptacle such as an NMR tube (symbolized by rectangle 25; corresponding to the NMR tube 124 of Fig. 1). The delivery line 23 has a total volume V_{L} ("line volume") which includes the volume V₁ of the receiving section 21. The receiving section 21 may be of a distinct volume, as indicated in Fig. 2, or simply a portion of the line forming the delivery line as in the embodiment of Fig. 1. The sample liquid is provided from the sample reservoir 12 (having a volume V_{Res} which may be assumed to be large) to the receiving section 21. Furthermore, a displacement reservoir 22, holding an adjustable volume V₂ of a displacement liquid, is connected to the receiving section 21, preferably at an upstream position thereof; in general the displacement liquid may or may not be the same as the sample liquid.

In order to prepare the device 11 for the injection process, an amount V₁ of sample liquid is delivered to the receiving section 21, and an amount V₂ of displacement liquid is provided in the displacement reservoir 22. For the injection process, the amount V₂ is delivered from the displacement reservoir 22 to the delivery line, more specifically the receiving section 21, thus forcing the liquid sample material toward and into the target receptacle 25. By virtue of the principle of displacement, the volume V_{D} ("delivery volume") that is injected is the amount that exceeds the volume of the delivery line, i.e., V_{D} = V_{L}-(V₁+V₂). Therefore, in order to have a positive amount V_{D} injected, the sum of the volumes V₁ and V₂ has to be larger than the volume V_{L} of the delivery line. Ideally, the volume V₂ of displacement liquid is calibrated to be equal to the volume V_{L} held in the delivery line 23, then V_{D} = V₁, and the delivery volume is equal to the volume of the receiving section. Furthermore, it may be preferable to ensure that the volume V₂ is not larger than the line volume V_{L}, in order to avoid that also some of the displacement liquid is propelled into the sample space / target receptacle 25.

By virtue of this procedure a sample liquid is rapidly deposited into the target receptacle in the spectrometer setup; in case of measurements like with DDNP, the liquid injected and a waiting solution are rapidly mixed. The volume of the sample liquid is controlled through the path length between the outlet of the collector and the optical liquid sensor. The volume of the waiting solution is determined when it is filled into target receptacle 25, through conventional volume control techniques (e.g., micropipettes with adjustable volume). Hence, the volume of sample liquid, waiting solution and the final mixture are controlled.

Another aspect of the invention relates to a sample adaptor as a main component of a sample injector arrangement mountable within the spectrometer setup, configured to cooperate with the injection system according to the invention. The sample adaptor will be connected at the outlet end of the delivery line of the injection system, and serves as a sample holder for a sample receptacle and provides the function of receiving the injected sample and guiding it to a position of measurement within the spectrometer setup.

Figs. 3 and 4 respectively illustrate a cross sectional and a perspective view of a sample injector arrangement 30 including a sample adaptor 41 according to a third embodiment (respectively corresponding to components 130 and 122 of the embodiment of Fig. 1). The sample adaptor 41 comprises an adaptor body 31 and an adaptor connector 32, which are joined, for instance releasably screwed together, to form the sample adapter and surround a cavity 40 able to withstand high pressures. The sample to be measured is held in the bottom part of an NMR tube 35 of known type, which is mounted in a conventional NMR sample holder piece 33 such as a holder piece for Bruker BioSpin spectrometers. The adaptor connector 32 is attached onto the holder piece 33, for instance by gluing, in a manner providing a hermetic seal that prevents any leak of liquid inside the NMR spectrometer; in a variant, the adaptor connector 32 and the sample holder piece 33 may be non-permanently joined, for instance by means of a sealed plug-in connection.

Two openings are provided in the adaptor body 31. A first opening is located at the center of the adaptor body and supports a straight tube 34; the tube 34 (which corresponds to the outlet end 24) reaches out below cavity 40 and extends through a central bore of the holder piece 33 and opening at its end into the space of the NMR tube 35, preferably just above the position of measurement. The other end of tube 34, which projects at the top of the sample adaptor 41, is connected to the end of the delivery line 128. A second opening 37 serves as outlet opening for depressurizing the cavity 40 during the injection process; for this purpose it may be connected to a vacuum line (e.g. vacuum line 120 shown in Fig. 1). This is advantageous for avoiding a build-up of pressure upon injection, which may even lead to leakage of liquid in the NMR probe. Preferably, the cavity 40 is designed sufficiently large so it can hold the entire amount of liquid corresponding to the line volume V_{L} in case of the failure of liquid sensor 117, which may lead to liquid being pressed up through tube 34.

After the measurement, the arrangement 30 is removed from the spectrometer setup, and the cavity 40 is opened (by screwing the adaptor body 31 off the adaptor connector 32, or detaching the entire sample adaptor 41 from the holder piece 33), thus separating the NMR tube from the sample adaptor 41 including the tube 34 from the NMR tube 35, to allow the release of the liquid collected therein.

In a further development of the sample adaptor, a controlled valve 38 may be provided arranged at the outlet opening 37. The valve 38 may be connected to the controller unit 129 for opening the outlet opening only during the short interval of the injection process.

The sample injector arrangement 30 is designed for preferable use with a narrow-bore (2 inch) NMR spectrometer and 5 mm outer diameter NMR tubes.

The sample injector arrangement 30 is supported within the spectrometer bore (such as the bore of the NMR magnet 121 in Fig. 1) by supporting components (not shown in the drawings) of known type of the respective spectrometer setup. For instance, in an NMR spectrometer setup, the bottom part of the holder piece 33 may rest on the probe of the NMR spectrometer setup and is thus positioned and centered within the spectrometer bore.

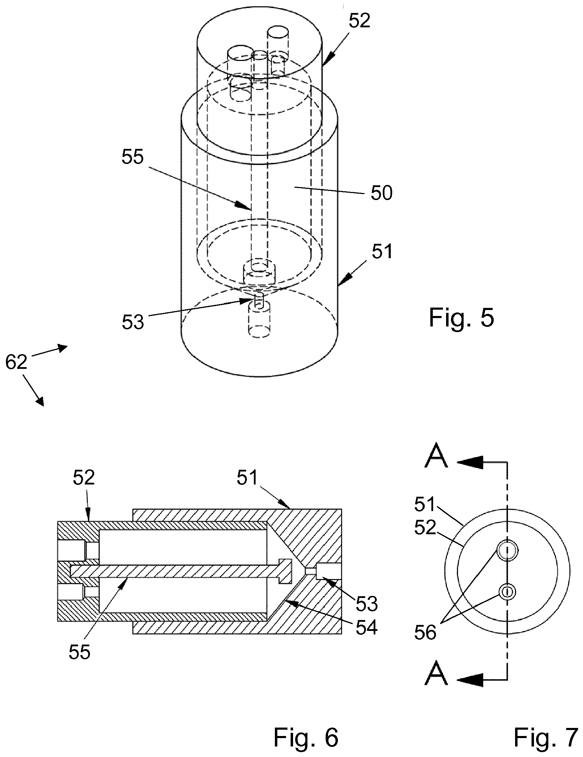

Figs. 5 to 7 illustrate one preferred implementation 62 of the collector 102, 12 of the devices of Figs. 1 and 2. The collector 62 is formed by two basically cup-like container components 51, 52 surrounding a collector volume 50. An outlet opening 53 is formed at the bottom surface of bottom component 51, where the delivery line 128 is connected. Top component 52 is inserted into bottom component 52 to close the collector volume 50, for instance by means of a screw connection, which advantageously also seals the collector volume 50. The inner bottom surface 54 of the bottom component is preferably shaped as a funnel ending in the outlet opening 53, in order to enable complete emptying. Furthermore, preferably a plunger-shaped vortex breaker 55 is provided which partially obstructs the outlet opening 53 towards the collector volume 50 in order to break any vortices arising during emptying of the collector 62 and prevent the introduction of gas into liquid leaving through the outlet. In addition to the outlet opening 53 in the bottom of the bottom component 51, the top component 52 contains openings 56, including one opening for introducing the sample liquid (corresponding to inlet 101 of Fig. 1) and one for a vacuum supply (connectable to vacuum line 106 of Fig. 1). The vacuum supply can be used as vacuum ejector in order to de-pressurize the NMR tube; for that purpose, they may additionally be connected to a waste outlet (not shown) for cleaning purposes.

## Claims

1. Sample delivery device (11, 100) for delivering a liquid sample material to a spectrometer setup, in particular NMR spectrometer setup, said device comprising
a sample reservoir (12,102) configured for containing said liquid sample material, and
a delivery line (20, 128) which is connectable, through an outlet end (24) thereof, to a sample holder arrangement (122) of said spectrometer setup,
wherein the delivery line (20, 128) has a known volume, referred to as line volume (V_{L}), and the delivery line (20,128) comprises a receiving section (21) and a delivery section (23) ending in said outlet end (24), wherein the receiving section (21), delivery section (23), and the outlet end (24) are in fluid communication, said receiving section being configured to receive, from the sample reservoir (12, 102), a first volume (V₁) of said liquid sample material to be delivered to said spectrometer setup,
a displacement reservoir (22, 115) connected to the receiving section (21) upstream thereof, the displacement reservoir (22, 115) being configured to contain a displacing liquid and deliver an adjustable second volume (V₂) of the displacing liquid to the delivery line (20, 128),
wherein
a sum of the first and the second volumes is larger than the line volume, thus displacing liquid from the receiving section (21) towards and through the outlet end (24).

2. The device of claim 1, wherein the delivery line (20) comprises a sensor (117) indicating the presence of an amount of liquid in the receiving section corresponding to the first volume.

3. The device of claim 2, wherein the sensor (117) is an optical liquid sensor, and wherein the portion of the delivery line (20,128) upstream of the sensor represents the receiving section (21), and the sensor being movable along the delivery line (20) for adjusting the first volume to a desired value.

4. The device of any one of the preceding claims, wherein the sample reservoir (102, 62) comprises a collector volume (50) having an outlet (53) connected to the delivery line (128), wherein within the collector volume (50) a vortex breaker element (55) is located in front said outlet (53), which vortex breaker element (55) is designed for reducing vortices when the liquid sample material is flowing out of the collector volume (50) through said outlet (53).

5. The device of claim 4, wherein the collector volume has a funnel-shaped bottom surface (54) ending into the outlet (53).

6. The device of any one of the preceding claims, wherein the displacement reservoir is configurable to deliver a second volume (V₂) which is not larger than the line volume (V_{L}).

7. The device of any one of the preceding claims, wherein the displacement reservoir (115) is realized as a cylinder with a moveable plunger or piston connected to an actuating mechanism for realizing the delivery of displacing liquid to the delivery line (20).

8. The device of claim 7, realized as a modular unit comprising the sample reservoir (12, 102), the displacement reservoir (22, 115) including an actuating mechanism thereof, and connection lines connecting the sample reservoir and displacement reservoir to the receiving section (21), preferably also comprising at least the receiving section (21) or the entire delivery line (20).

9. The device of any one of the preceding claims, wherein the sample reservoir (12, 102) is connected to a vacuum line through a valve (107), allowing depressurizing of the sample reservoir (12, 102) for degassing the sample material contained in the sample reservoir.

10. Method for delivering a liquid sample material to a sample holder arrangement (122) of a spectrometer setup, in particular NMR spectrometer setup, comprising:
- providing a liquid sample material, of which at least a fraction is to be delivered to said spectrometer setup,
- transferring a first volume of said liquid sample material into a receiving section (21) of a delivery line (20), wherein the delivery line (20) comprises, downstream of the receiving section (21), a delivery section (23) ending in an outlet end (24) through which the delivery line (20) is connected to the sample holder arrangement (122),
- providing an amount of a displacing liquid in a displacement reservoir (22, 115), said displacement reservoir being connected to the receiving section (21) of the delivery line upstream thereof,
- delivering a second volume of the displacing liquid from the displacement reservoir (22, 115) to the delivery line (20), thus forcing the liquid sample material in the receiving section through the delivery line toward and into said spectrometer setup,
wherein the delivery line (20) has a known volume, referred to as line volume, and wherein a sum of the first and the second volumes is larger than the line volume.

11. The method of claim 10, wherein the liquid sample material is degassed within the sample reservoir (12, 102) by depressurized the latter, prior to transferring a first volume of said liquid sample material into the receiving section (21).

12. A sample adaptor (41) attachable to an spectrometer sample tube, the sample adaptor being configured for being connected to a sample delivery device (11, 100) and including:
an adaptor body (31), and
an adaptor connector (32) mounted, preferably releasably, to the adaptor body, the adaptor connector (32) configured for pressure-tight mounting of a spectrometer sample tube (124, 35),
the adaptor body (31) and the adaptor connector (32) defining a cavity (40) forming an additional headspace of the spectrometer sample tube,
wherein the adaptor body (31) is provided with an opening for mounting a tube (123, 34) as an outlet end of said sample delivery device, wherein said tube extends with its tip into the spectrometer sample tube when the latter is mounted.

13. The sample adaptor of the previous claim, wherein the adapter body (31) has an outlet opening extending (37) from the cavity (40), said outlet opening preferably being connectable to a vacuum line.

14. The sample adaptor of the previous claim, comprising a controlled valve arranged at the outlet opening, wherein the valve is connectable to a controller of the sample delivery device (126) for opening the outlet opening (37) only during injection of a liquid sample through the tube forming the outlet end.

15. A sample injection system including a sample delivery device of any one of claims 1 to 9 connected to a sample adaptor attachable to an spectrometer sample tube according to any one of claims 12 to 14.
